# EUROPEAN PATENT APPLICATION

(11) **EP 4 541 935 A2**
(43) Date of publication of application: **23.04.2025**
(21) Application number: 24201921.4
(22) Date of filing: 23.09.2024
(51) Int. Cl.: C23C 16/455, C23C 16/458

(54) **GAS INJECTOR**

(30) Priority: 26.09.2023 US 202363540524 P
(71) Applicant: ASM IP Holding B.V., 1322 AP Almere (NL)
(72) Inventor: OOSTERLAKEN, Theodorus G.M., 1322 AP Almere (NL)
(74) Representative: V.O.

(57) **Abstract**

A gas injector to provide, in use, a process gas into a process chamber of an apparatus constructed and arranged to process a plurality of substrates. The gas injector comprising a primary conduit elongated along a main axis and a feed end at one end constructed and arranged to connect to a process gas line of the apparatus; and a plurality of secondary conduits having a bowed shape in a plane perpendicular to the main axis and connected with their first end to the primary conduit and being provided with a gas exhaust opening at a second end to provide the process gas into the process chamber.

## Description

### FIELD OF INVENTION

The disclosure may relate to a gas injector and an apparatus constructed and arranged to process a plurality of substrates with such gas injector. The gas injector may be used to provide a process gas into the process chamber. The gas injector may have a primary conduit elongated along a main axis and an inlet at one end constructed and arranged to connect to a process gas line of the apparatus.

### BACKGROUND OF THE DISCLOSURE

During processes such as Atomic Layer Deposition (ALD), Epitaxy, and Chemical Vapor Deposition (CVD) precursors, which may be in the form of a gas, may be provided to a substrate. These precursors are often stored in a container or storage vessel from where they are transported to the process chamber via a gas injector to react with the substrate. A plasma may be provided to improve the reactivity of the precursors in the process chamber.

The ALD manufacturing process typically involves pulsing precursors with the gas injector into the process chamber, allowing them to react with the substrate surface, and then purging the chamber before introducing the next precursor. For the reaction efficiency of the precursors in the process chamber, the concentration throughout the process chamber may be of importance.

### SUMMARY OF THE DISCLOSURE

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

It may be an objective to provide a gas injector and apparatus in which the efficiency is improved

Accordingly, there may be provided a gas injector to provide in use a process gas into a process chamber of an apparatus constructed and arranged to process a plurality of substrates. The gas injector may comprise a primary conduit elongated along a main axis and an inlet at one end constructed and arranged to connect to a process gas line of the apparatus. A plurality of secondary conduits connected with their first end to the primary conduit substantially perpendicular to the main axis of the primary conduit and being provided with a gas exhaust opening at a second end of the secondary conduit may provide the process gas into the process chamber.

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

### BRIEF DESCRIPTION OF THE DRAWING FIGURES

While the specification concludes with claims particularly pointing out and distinctly claiming what is regarded as embodiments, the advantages of embodiments of the disclosure may be more readily ascertained from the description of certain examples of the embodiments of the disclosure when read in conjunction with the accompanying drawing figures, in which:
Figure 1 is a schematic and cross-sectional side view on a gas injector;
Figure 2 is a schematic and cross-sectional bottom view on the gas injector of figure 1;
Figure 3 is a schematic and cross-sectional side view on the gas injector of figure 1 showing its position relative to a substrate;
Figure 4 is a schematic and cross-sectional view on an apparatus constructed and arranged to process a plurality of substrates with the gas injector of figure 1.
Figure 5 is a schematic and cross-sectional top view on the gas injector showing its position relative to the substrate in the apparatus of figure 4; and,
Figure 6 is a schematic and cross-sectional top view on the gas injector when moved above the substrate in the apparatus of figure 4.

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below

The illustrations presented herein are not meant to be actual views of any particular material, structure, or device, but are merely idealized representations that are used to describe embodiments of the disclosure.

The particular implementations shown and described are illustrative of the invention and its best mode and are not intended to otherwise limit the scope of the aspects and implementations in any way. Indeed, for the sake of brevity, conventional manufacturing, connection, preparation, and other functional aspects of the system may not be described in detail. Furthermore, the connecting lines shown in the various figures are intended to represent exemplary functional relationships and/or physical couplings between the various elements. Many alternative or additional functional relationship or physical connections may be present in the practical system, and/or may be absent in some embodiments.

It is to be understood that the configurations and/or approaches described herein are exemplary in nature, and that these specific embodiments or examples are not to be considered in a limiting sense, because numerous variations are possible. The specific routines or methods described herein may represent one or more of any number of processing strategies. Thus, the various acts illustrated may be performed in the sequence illustrated, in other sequences, or omitted in some cases.

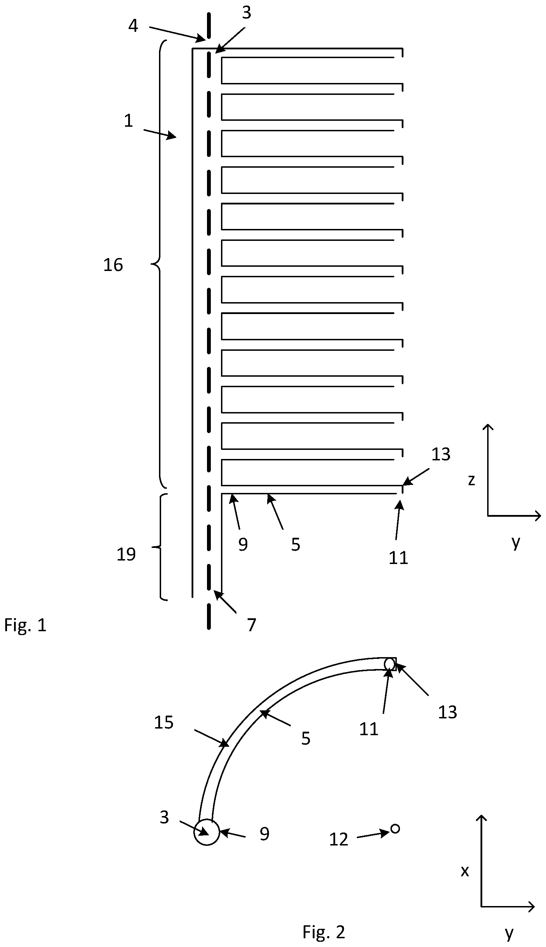

Figure 1 is a schematic and cross-sectional side view on a gas injector according to an embodiment. The gas injector 1 may be used to provide in use a process gas into a process chamber of an apparatus constructed and arranged to process a plurality of substrates. The gas injector 1 may comprise a primary conduit 3 elongated along a main axis 4 parallel to the Z axis. The primary conduit 3 may comprise a feed end 7 at one end constructed and arranged to connect to a process gas line of the apparatus (not shown).

The gas injector 1 may comprise at plurality of secondary conduits 5. The secondary conduits 5 may be connected to the primary conduit 3. The secondary conduit may be connected with a first end 9 to the primary conduit 3 substantially perpendicular to the main axis of the primary conduit. The secondary conduits 5 may be provided with a gas exhaust opening 11 at a second end 13 of the secondary conduit 5 to provide the process gas into the process chamber.

Figure 2 is a schematic and cross-sectional bottom view on the gas injector 1 of figure 1 to show the gas exhaust opening 11. The secondary conduit 5 may have a bowed shape 15 in a plane substantially perpendicular to the main axis of the primary conduit 3. The plane may be parallel to the X, Y axis. In use the plane may correspond to the horizontal plane in which the substrates are positioned in the apparatus. The gas exhaust opening 11 may be at the bottom surface of the secondary conduit 5. In this way the gas exhaust opening 11 may provide the process gas at the top surface of a lower positioned substrate.

The bowed shape 15 may form a part of a substantial circle shape having a radius between 8 and 22 cm, preferably between 12 and 18 cm around a first axis 12. The first axis 12 may be substantially parallel to the main axis 4 of the primary conduit 3 and extend in the Z-direction. The secondary conduit 5 may have a length from the first end 9 to the second end 13 between 8 and 22 cm, and preferably between 12 and 18 cm. In use the first axis 12 may correspond to the vertical Z axis of the apparatus perpendicular to a plane in which the substrates are positioned in the apparatus. The first axis 12 may be positioned close to the center of the substrates which are positioned in the apparatus.

Returning to Figure 1, the primary conduit 3 may have a branched part 16 connected with the plurality of secondary conduits 5. The primary conduit 3 may have an unbranched part 19 which is constructed and arranged to connect the branched part 16 to the feed end 7. The unbranched part 19 may have a length of between 10 to 40, preferably 15 to 30 cm.

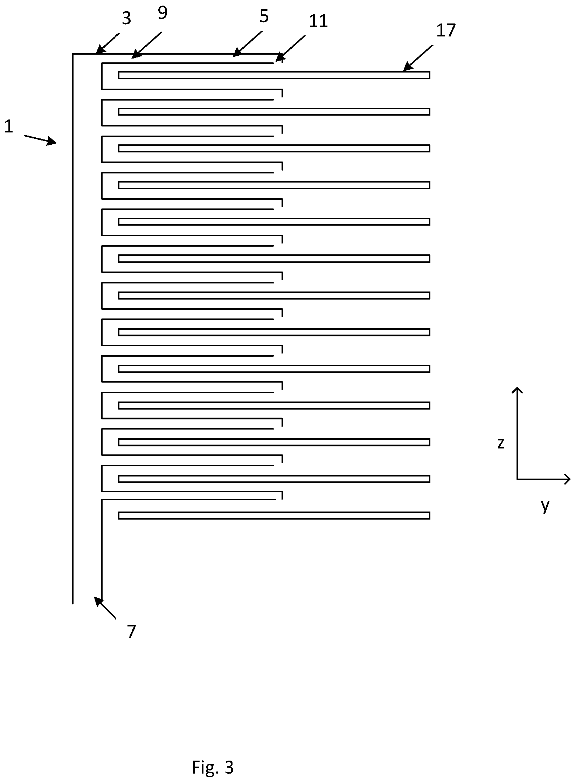

Figure 3 is a schematic and cross-sectional side view on the gas injector 1 of figure 1 showing its position relative to substrates 17. As shown the gas exhaust opening 11 may be at the bottom surface of the secondary conduit 5. In this way the gas exhaust opening 11 may provide the process gas at the top surface of a lower positioned substrate 17.

The plurality of secondary conduits 5 may be equal to the number of substrates 17 that is processed in the process chamber. Although only 13 substrates are illustrated, the present invention is not limited to this number of substrates. The plurality of secondary conduits 5 may be between 2 and 201, preferably between 25 and 151, and most preferably between 50 and 101.

The plurality of secondary conduits 5 may be spaced apart along the primary conduit 3 at substantially the same distance along the main axis. The same distance may be between 0.4 to 5 cm, more preferably 0.6 and 4 cm and most preferably between 0.8 and 3 cm. The plurality of secondary conduits 5 may be provided along a substantially straight line along the main axis of the primary conduit 3.

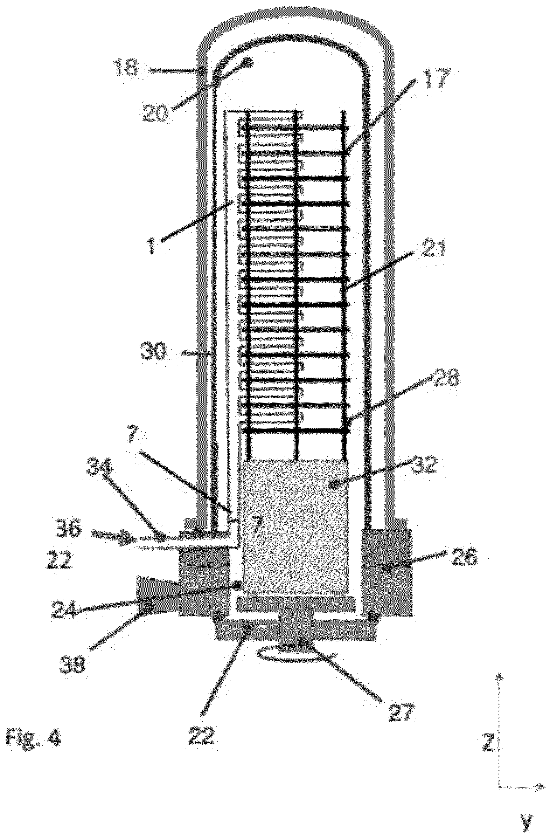

Figure 4 is a schematic and cross-sectional view on an apparatus constructed and arranged to process a plurality of substrates and with the gas injector 1 of figure 1. It shows a process tube 18 defining a process chamber 20. The furnace may comprise a vertically movable door 22 configured to close off a central inlet opening 24 in lower and upper flanges 26. The upper and lower flanges 26 may partially close an open end of the process tube 18. A liner 30 may extend along the process tube 18 to protect the tube.

The vertically movable door 22 may also be configured to support a wafer boat 28 that is configured to hold a plurality of substrates 17 supported on a pedestal 32. The wafer boat 28 may have a plurality of boat rails 21. The boat rails 21 may be provided with spaces to form edges to support the substrate 17 in the wafer boat 28.

The vertically moveable door 22 may be provided with a drive 27 to allow for rotation 29 of the wafer boat 28 in the process chamber 20. This rotation may allow the heat uniformity for the substrates 17 in the boat 28 to be improved. In between the drive 27 and the wafer boat 28 the pedestal 32 may be provided with heaters and/or thermal insulators which may allow the heat uniformity to be further improved. The liner 30 may be closed at an upper end for example with a dome shape and may be substantially closed for gases above inlet opening 24.

The gas injector 1 may be provided inside the process chamber 20 extending in a substantially vertical direction over substantially a height of the wafer boat 28. The liner 30 extending along the process tube 18 may have a radially outwardly extending bulge 31 to accommodate the gas injector 1.

The first precursor provided at the feed end 7 of the gas injector 1 may be a sublimated solid metal precursor. The apparatus may be constructed to provide the sublimated solid metal precursor from a precursor vessel to the process chamber

The first precursor provided at the feed end 7 of the gas injector 1 may be a vaporized metal chloride. The metal chloride may be selected from Titanium tetrachloride (TiCl₄), Vanadium tetrachloride (VCl₄), Molybdenum pentachloride (MoCls), Molybdenum dioxi dichloride (MoO₂Cl₂), Niobium pentachloride (NbCl₅), Tantalum pentachloride (TaCl₅), Aluminum trichloride (AlCl₃), Hafnium tetrachloride (HfCl₄), and Zirconium tetrachloride (ZrCl₄). The apparatus may be constructed to provide the vaporized metal precursor from a precursor vessel to the process chamber

The gas injector 1 may comprise a feed end 7 operationally connected to a first feed line 34 which may be connected to a second source of a first precursor 36. The feed end 7 may be operationally connected to a second feed line (not shown) which may be connected to a second source comprising nitrogen for purging or a second precursor for processing.

The second precursor provided at the feed end 7 of the gas injector 1 may comprise ammonia. The first and second precursor may react with each other on the substrate 17 forming metal nitride on the surface of the substrate 17.

The apparatus may be provided with a pump connection 38 to pump gasses out of the process chamber 20.

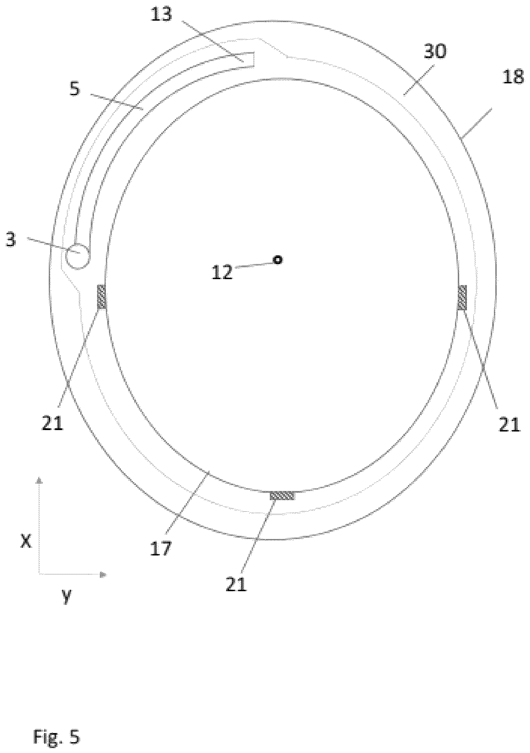

Figure 5 is a schematic and cross-sectional top view on the gas injector 1 of Figure 1 showing its position relative to the substrate 17. The secondary conduits 5 may be provided with the gas exhaust opening at the bottom side at the second end 13 to provide the process gas into the process chamber but that is not visible in this top view.

The secondary conduit 5 may have a bowed shape in a plane substantially perpendicular to the main axis of the primary conduit 3. The plane may be parallel to the X, Y axis. and correspond to the horizontal plane in which the substrates 17 are positioned in the apparatus in use.

The bowed shape may form a part of a substantial circle shape having a radius between 8 and 22 cm, preferably between 12 and 18 cm around the first axis 12. The first axis 12 may be substantially parallel to the main axis 4 of the primary conduit 3. The fist axis 12 may be positioned close to the center of the substrates 17 which are positioned in the apparatus

The secondary conduit 5 may have a length from the first end 9 to the second end 13 between 8 and 22 cm, and preferably between 12 and 18 cm. This may correspond to the radius of the substrates 17 used by the apparatus.

The substrate 17 may be loaded in the apparatus with the wafer boat 28 (see figure 4) having a plurality of boat rails 21. The boat rails 21 may be provided with spaces creating edges to support the substrate 17 in the wafer boat.

A liner 30 may extend along the process tube 18 to protect the tube. The liner 30 extending along the process tube 18 may have a radially outwardly extending bulge 31. The bulge 31 may accommodate the gas injector 1 on the inside when it is retracted away from the substrate 17 as in figure 5. Retracting the gas injector 1 may be necessary when the vertically movable door 22 (see figure 4) supporting the wafer boat 28 with a plurality of substrates 17 may be moved up to bring the substrates 17 in the process chamber 20.

The vertically moveable door 22 may be provided with a drive 27 to allow for rotation 29 of the wafer boat 28 in the process chamber 20. The wafer boat 28 may have a plurality of boat rails 21 to support the substrates 17 in the wafer boat 28. Retracting the gas injector 1 may be necessary when the wafer boat 28 is rotated to circumvent that the boat rails 21 touch the gas injector 1.

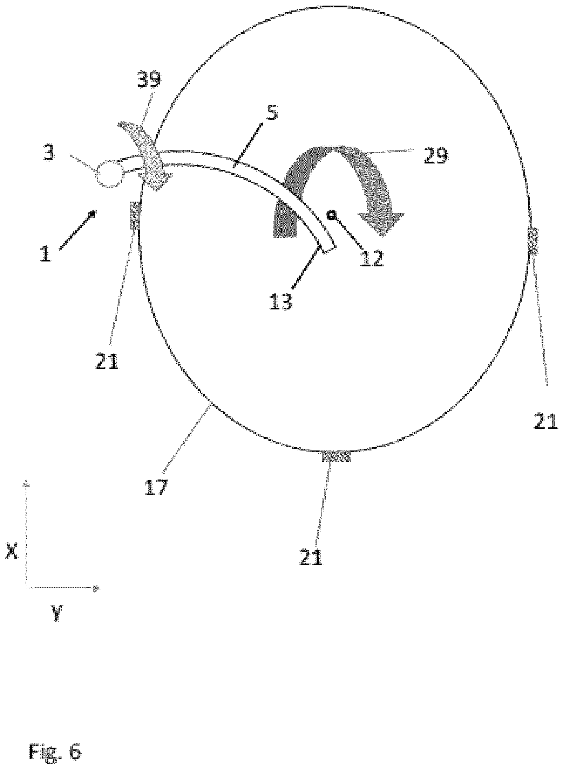

When the vertically moveable door 22 is closed and no boat rail 21 is in the way of the gas injector 1 the gas injector 1 may be moved in a rotational way 39 (around the Z-axis) as depicted in figure 6. Figure 6 is a schematic and cross-sectional top view on the gas injector of figure 1. The gas exhaust opening (not shown) may be moveable above the substrate 17 by rotating 39 the secondary conduit 5 with an actuator operably connected to a controller (not shown).

The gas exhaust opening (not shown) may be moveable above the center of the substrate 17. This may have the advantage that the concentration of the precursor may be higher at the center of the substrate 17 and lower in the area surrounding the substrate 17 in the process chamber 20. This may improve the speed of the process and/or the efficiency of precursor usage because the precursor is quicker and at higher concentration in the center of the substrate 17. If one provides the precursor from the side and relies on diffusion to reach the center of the substrate a lot of time may be involved.

The apparatus may be provided with a bearing constructed and arranged to mount the gas injector 1 rotatable in the apparatus. The bearing may allow the gas injector 1 to rotate 39 substantially around the main axis to move the gas exhaust opening in between the substrates 17. The bearing may be provided at the feed end 7 (in figure 1) of the gas injector 1. This has the advantage that the temperature and the precursor concentration at the lower end may be lower so that there is less risk of a reaction with precursor leading to blocking of the bearing.

Alternatively, the gas injector 1 may be moved in a linear way with linear bearings. It may however take more space to accommodate the gas injector 1 in retracted position in the bulge 31 of the liner 30 when moved away linearly.

The gas injector 1 may be provided with a cooler (not shown) to cool the gas injector 1. The primary conduit 3 may be provided with the cooler to cool the primary conduit 3. The secondary conduit 5 may be provided with the cooler to cool the secondary conduit. The cooler may comprise a cooling line constructed and arranged to flow a cooling fluid through the gas injector 1 independent from the process gas. The cooling line may be part of a cooling circuit in which the cooling fluid is re-cycled.

The cooling of the gas injector 1 may lead to non-uniformity of the temperature of the substrate 17 in the process chamber 20. To alleviate this the wafer boat 28 and substrates 17 which may be supported therein may be rotated with the help of the drive 27 operably connected to the controller (not shown). Retracting the gas injector 1 may be necessary when the wafer boat 28 is rotated to circumvent that the boat rails 21 touch the gas injector 1. The controller may be programmed to calculate information of a position of the boat rail 21 as a function of the boat rotation 29 and the actuator may be controlled to move the gas injector 1 out of the position in between the substrates 17 when a boat rail 21 is coming to close to the gas injector 1.

The gas exhaust opening 11 may have a surface of at least between 1 to 200 mm², preferably 4 to 100 mm², preferably 10 to 50 mm². Optionally, the secondary conduits 5 may be provided with a plurality of gas exhaust openings 11 along its length.

The gas injector 1 may be manufactured from Ceramics. The ceramics may be selected from Silicon carbide (SiC), Silicon oxide (SiOx), Silicon, or Aluminium oxide (AlOx). Optionally, the gas injector 1 may be made from metal.

Although illustrative embodiments of the present invention have been described above, in part with reference to the accompanying drawings, it is to be understood that the invention is not limited to these embodiments. Variations to the disclosed embodiments can be understood and effected by those skilled in the art in practicing the claimed invention, from a study of the drawings, the disclosure, and the appended claims.

Reference throughout this specification to "one embodiment" or "an embodiment" means that a particular feature, structure or characteristic described in connection with the embodiment is included in at least one embodiment of the present invention. Thus, the appearances of the phrases "in one embodiment" or "in an embodiment" in various places throughout this specification are not necessarily all referring to the same embodiment. Furthermore, it is noted that particular features, structures, or characteristics of one or more embodiments may be combined in any suitable manner to form new, not explicitly described embodiments.

## Claims

1. A gas injector to provide, in use, a process gas into a process chamber of an apparatus constructed and arranged to process a plurality of substrates, the gas injector comprising:
a primary conduit elongated along a main axis and comprising a feed end at one end of the primary conduit, the feed end being constructed and arranged to connect to a process gas line of the apparatus; and,
a plurality of secondary conduits connected with their first ends to the primary conduit substantially perpendicular to the main axis of the primary conduit and being provided with a gas exhaust opening at a second end of the secondary conduits to provide the process gas into the process chamber.

2. The gas injector according to claim 1, wherein the secondary conduit has a bowed shape in a plane substantially perpendicular to the main axis of the primary conduit.

3. The gas injector according to claim 2, wherein the bowed shape substantially forms a part of a substantial circle shape having a radius between 8 and 22 cm, preferably between 12 and 18 cm, centered at a first axis substantially parallel to the main axis of the primary conduit.

4. The gas injector according to any one of claims 1-3, wherein the secondary conduit has a length from the first end to the second end between 8 and 22 cm, preferably between 12 and 18 cm.

5. The gas injector according to any one of claims 1-4, wherein the primary conduit has a branched part connected with the plurality of secondary conduits and an unbranched part which is constructed and arranged to connect the branched part to the feed end and the unbranched part has length between 10 to 40, preferably 15 to 30 cm.

6. The gas injector according to any one of claims 1-5, wherein the plurality of secondary conduits numbers between 2 and 201, preferably between 25 and 151, and most preferably between 50 and 101.

7. The gas injector according to any one of claims 1-6, wherein the plurality of secondary conduits are spaced apart from each other along the primary conduit at substantially the same distance along the main axis.

8. The gas injector according to any one of claims 1-7, wherein the plurality of secondary conduits are provided along a substantially straight line along the main axis of the primary conduit.

9. The gas injector according to any one of claims 1-8, wherein the gas injector is provided with a cooler to cool the gas injector.

10. The gas injector according to claim 9, wherein the primary conduit is provided with the cooler to cool the primary conduit.

11. The gas injector according to claim 9, wherein the secondary conduits are provided with the cooler to cool the secondary conduit.

12. An apparatus constructed and arranged to process a plurality of substrates, comprising:
a process tube creating a process chamber; and
a door configured to support a wafer boat with the plurality of substrates in the process chamber, wherein the apparatus is provided with the gas injector according to claim 1.

13. The apparatus according to claim 12, wherein the gas injector is constructed and arranged moveably in the apparatus to allow the gas exhaust opening to be moved between the substrates.

14. The apparatus according to claim 12 or 13, wherein the process tube is provided with liner and wherein the liner is provided with a bulge constructed and arranged to provide space on the inside of the process tube for the gas injector to retract.

15. The apparatus according to any one of claims 12-14, wherein the wafer boat is constructed and arranged to process a number of substrates equal to the number of secondary conduits of the gas injector.

16. The apparatus according to any one of claims 12-15, wherein the apparatus is constructed to provide a sublimated solid metal precursor from a precursor vessel to the process chamber.

17. The apparatus according to any one of claims 12-16, wherein the apparatus is constructed to provide a vaporized metal chloride selected from Titanium tetrachloride (TiCl₄), Vanadium tetrachloride (VCl₄), Molybdenum pentachloride (MoCl₅), Molybdenum dioxi dichloride (MoO₂Cl₂), Niobium pentachloride (NbCl₅), Tantalum pentachloride (TaCl₅), Aluminum trichloride (AlCl₃), Hafnium tetrachloride (HfCl₄), and Zirconium tetrachloride (ZrCl₄) to the process chamber.

18. An apparatus constructed and arranged to process a plurality of substrates, comprising:
a process tube creating a process chamber;
a gas injector with a gas exhaust opening to provide process gas into the process chamber; and
a door configured to support a wafer boat with a plurality of substrates in the process chamber, wherein the gas injector is constructed and arranged moveably in the apparatus to allow an actuator operably connected to a controller to move the gas exhaust opening in between the substrates.

19. The apparatus according to claim 18, wherein the gas injector is provided with a cooler to cool the gas injector and the wafer boat is provided with a boat rail to support the substrates in the wafer boat and the apparatus is provided with a drive operably connected to the controller and constructed and arranged to rotate the wafer boat.

20. The apparatus according to claim 19, wherein the controller is programmed to calculate information of a position of the boat rail as a function of a boat rotation and the actuator is controlled to move the gas injector out of the position in between the substrates when the boat rail is coming too close to the injector.
